# FASCICULE DE BREVET EUROPEEN

(11) **EP 3 011 592 B1**
(45) Date de publication et mention de la délivrance du brevet: **05.06.2019**
(21) Numéro de dépôt: 14729926.7
(22) Date de dépôt: 16.06.2014
(51) Int. Cl.: H01L 31/043, H01L 31/0224, H01L 31/0725, H01L 31/18

(54) **CÉLLULE SOLAIRE MULTI-JONCTIONS, SON PROCÉDÉ DE FORMATION ET PROCÉDÉS D'UTILISATION**
MEHRFACHSOLARZELLE UND DEREN HERSTELLUNGS- UND ANWENDUNGSVERFAHREN
MULTI-JUNCTION SOLAR CELL, METHOD OF FABRICATION AND METHODS OF UTILISATION

(30) Priorité: 18.06.2013 FR 1355735
(43) Date de publication de la demande: 27.04.2016
(73) Titulaire: Commissariat à l'Énergie Atomique et aux Énergies Alternatives, 75015 Paris (FR)
(72) Inventeur: BAUDRIT, Mathieu, 73000 Chambéry (FR); SIGNAMARCHEIX, Thomas, 38240 Meylan (FR)
(74) Mandataire: Brevalex
(86) Numéro de dépôt international: PCT/EP2014/062522
(87) Numéro de publication internationale: WO 2014/202511

(56) Documents cités:
- WO-A1-2012/109448
- US-A1- 2006 162 768
- US-A1- 2007 193 622
- US-A1- 2010 089 440

## Description

### DOMAINE TECHNIQUE

La présente invention concerne une cellule solaire multi-jonctions et un procédé de fabrication d'une telle cellule solaire. La présente invention concerne plus particulièrement une cellule solaire multi-jonctions destinée à être utilisée pour des applications photovoltaïques.

### ÉTAT DE LA TECHNIQUE ANTÉRIEURE

Dans le domaine des cellules solaires photovoltaïques à haut rendement de conversion de l'énergie solaire, on cherche à optimiser la collecte des photons du spectre solaire incident.

Des cellules solaires dites « multi-jonctions » ont été proposées. Les cellules solaires multi-jonctions comprennent un empilement de plusieurs sous-cellules, chaque sous-cellule étant constituée d'un empilement de différentes couches semi-conductrices formant une jonction PN. Les jonctions PN de chaque sous-cellule sont formées de façon à présenter chacune une énergie de bande interdite différente. Chaque sous-cellule absorbe ainsi une portion réduite du spectre solaire mais avec un rendement élevé. Il en résulte un rendement global accru d'une telle cellule solaire par rapport à une cellule solaire à jonction unique en silicium.

Les cellules solaires multi-jonctions sont couramment formées par croissance par épitaxie des différentes couches constituant les différentes sous-cellules sur un même substrat. Les cellules solaires multi-jonctions formées par un tel procédé sont dites « monolithiques ».

Dans une cellule solaire multi-jonctions monolithique en fonctionnement, une différence de potentiel est appliquée entre deux électrodes disposées de part et d'autre de l'empilement des différentes sous-cellules. Les sous-cellules sont connectées en série par l'intermédiaire de diodes tunnel ou jonctions tunnel disposées entre deux sous-cellules voisines. Les sous-cellules étant connectées en série, la sous-cellule absorbant le moins d'énergie du spectre incident, et fournissant donc le moins de courant, limite les autres cellules à cette valeur de courant. La puissance maximale fournie par une cellule solaire multi-jonctions monolithique correspond au produit du minimum des courants délivrés par les différentes sous-cellules par la tension aux bornes de la cellule multi-jonctions (correspondant à la somme des tensions aux bornes des sous-cellules), et non pas à la somme des puissances maximales fournies par chaque sous-cellule.

Un avantage des cellules solaires multi-jonctions monolithiques réside dans le fait qu'elles sont fabriquées par des procédés simples à mettre en oeuvre et bien maîtrisés. Il en résulte une capacité de production élevée et des cellules solaires multi-jonctions de bonne qualité.

Un inconvénient des cellules solaires multi-jonctions monolithiques est lié au fait que les différentes sous-cellules sont connectées en série. Il en résulte que l'optimum de fonctionnement de telles cellules solaires, permettant d'obtenir la puissance maximale fournie par la cellule solaire, ne correspond pas à l'optimum de fonctionnement de chaque sous-cellule. En outre, si une des sous-cellules présente une variation de sa performance lors de son fonctionnement, par exemple due à un spectre solaire réel non conforme au spectre solaire utilisé pour la conception de la cellule solaire ou due à un élément externe tel qu'une optique de concentration ou due à une dégradation de ses caractéristiques, ceci entraîne une réduction de la performance globale de la cellule solaire. Il en résulte un rendement réduit de telles cellules solaires.

Pour augmenter la puissance délivrée par une cellule solaire multi-jonctions monolithique, une solution consiste à fabriquer la cellule de sorte que chaque sous-cellule délivre le même courant pour un spectre incident donné. On parle d'« alignement en courant » des sous-cellules. Cependant, il en résulte un procédé de fabrication plus complexe de la cellule solaire. En outre, l'alignement en courant n'est valable que pour le spectre incident choisi pour l'optimisation de la cellule solaire.

Par ailleurs, au lieu d'être formées de manière monolithique, les cellules solaires multi-jonctions peuvent être formées par un procédé d'assemblage mécanique des différentes sous-cellules. De telles cellules solaires multi-jonctions sont dites « multi-terminales ». Chaque sous-cellule est formée indépendamment des autres sous-cellules, par exemple par croissance par épitaxie sur un substrat. Des électrodes, par exemple des plots conducteurs, sont formées de part et d'autre de chaque sous-cellule. Les sous-cellules sont ensuite assemblées mécaniquement les unes avec les autres. Dans une cellule solaire multi-jonctions multi-terminale en fonctionnement, une différence de potentiel est appliquée entre les deux électrodes de chaque sous-cellule. Le fonctionnement électrique de chaque sous-cellule est indépendant de celui des autres sous-cellules.

Un avantage des cellules solaires multi-jonctions multi-terminales réside dans le fait que le fonctionnement de chaque sous-cellule peut être optimisé individuellement. La puissance maximale fournie par une cellule solaire multi-jonctions multi-terminale correspond à la somme des puissances maximales fournies par chaque sous-cellule. En outre, une dégradation de la performance d'une des sous-cellules n'entraîne pas de dégradation des performances des autres sous-cellules. Il en résulte un rendement élevé de telles cellules solaires.

Un autre avantage des cellules solaires multi-jonctions multi-terminales réside dans le fait que l'alignement en courant de chaque sous-cellule pour un spectre incident donné n'est pas nécessaire.

En revanche, un tel procédé d'assemblage mécanique des sous-cellules nécessite un bon contrôle de l'alignement des sous-cellules de façon que les sous-cellules des niveaux supérieurs n'entraînent pas d'effet d'ombrage sur les sous-cellules des niveaux inférieurs. En effet, si les plots conducteurs formant les électrodes des différentes sous-cellules ne sont pas bien alignés entre eux, ceci entraîne une diminution de la quantité de photons absorbés par les sous-cellules sous-jacentes, c'est-à-dire les sous-cellules disposées sous la sous-cellule dont une des faces constitue la face avant de l'assemblage mécanique.

Un inconvénient des cellules solaires multi-jonctions multi-terminales réside dans la complexité des procédés de fabrication existants. En outre, les sous-cellules étant fabriquées individuellement sur des substrats différents, il en résulte un coût de fabrication élevé.

Un exemple d'une cellule solaire à deux jonctions formée par croissance par épitaxie est décrit dans la demande de brevet US 2010/0089440. Selon un mode de réalisation décrit dans ce document, la cellule solaire comprend trois terminaux. Un premier terminal et un deuxième terminal sont connectés respectivement à l'une et l'autre des deux sous-cellules, et un troisième terminal est connecté à une couche conductrice disposée entre les deux sous-cellules. Dans une telle cellule solaire, une différence de potentiel peut être appliquée soit entre les premier et deuxième terminaux, soit entre les premier et troisième terminaux, soit entre les deuxième et troisième terminaux. Dans le cas où une différence de potentiel est appliquée entre le premier terminal et le deuxième terminal, la cellule solaire fonctionne comme une cellule solaire à deux jonctions monolithique classique, les deux sous-cellules étant connectées en série. Il est également possible de vérifier le bon fonctionnement de chaque sous-cellule indépendamment de l'autre sous-cellule en appliquant une différence de potentiel entre le premier terminal et le troisième terminal ou entre le deuxième terminal et le troisième terminal. Ceci permet par exemple de vérifier que les courants fournis par les deux sous-cellules sont égaux. Un inconvénient d'une telle cellule solaire à deux jonctions réside dans le fait que les deux sous-cellules ne peuvent pas être mises en fonctionnement simultanément indépendamment l'une de l'autre.

Il se pose donc le problème de réaliser, par un procédé de fabrication simple à mettre en oeuvre, une cellule solaire multi-jonctions dans laquelle les différentes sous-cellules peuvent être connectées simultanément indépendamment les unes des autres.

Il se pose également le problème de réaliser une cellule solaire multi-jonctions présentant un rendement optimal.

### EXPOSÉ DE L'INVENTION

La présente invention vise notamment à résoudre ces problèmes.

La présente invention concerne une cellule solaire comprenant un empilement d'au moins deux sous-cellules, une diode tunnel, comportant une première et une seconde couches superposées dopées selon des types de conductivités opposés, étant interposée entre deux sous-cellules voisines. Une première électrode et une deuxième électrode sont respectivement en contact avec l'une et l'autre des faces disposées aux extrémités de l'empilement. Pour au moins une diode tunnel, une troisième électrode et une quatrième électrode sont respectivement en contact électrique avec la première couche et la seconde couche de la diode tunnel.

Selon un mode de réalisation de la présente invention, pour chaque diode tunnel, une troisième électrode et une quatrième électrode sont respectivement en contact électrique avec la première couche et la seconde couche de la diode tunnel. Les troisième et quatrième électrodes sont utilisées comme électrodes supplémentaires permettant de polariser chaque sous-cellule indépendamment des autres sous-cellules.

Selon un mode de réalisation de la présente invention, la première électrode est en contact avec la face de l'empilement destinée à être exposée au rayonnement lumineux et recouvre partiellement cette face, et la deuxième électrode est en contact avec la face de l'empilement opposée à ladite face destinée à être exposée au rayonnement lumineux et recouvre entièrement cette face.

Pour ladite au moins une diode tunnel, les troisième et quatrième électrodes peuvent être disposées :
- sur les première et seconde couches de la diode tunnel du côté de la face de l'empilement destinée à être exposée au rayonnement lumineux;
- ou sur les première et seconde couches de la diode tunnel du côté de la face de l'empilement opposée à ladite face destinée à être exposée au rayonnement lumineux.

Selon un mode de réalisation de la présente invention, au moins une diode tunnel comporte en outre une première et une seconde couches barrière conductrices, disposées de part et d'autre de l'empilement des première et seconde couches, respectivement en contact avec la première couche et la seconde couche. La troisième électrode associée à cette diode tunnel peut être en contact direct avec la première couche barrière et/ou la quatrième électrode associée à cette diode tunnel peut être en contact direct avec la seconde couche barrière.

Selon un mode de réalisation de la présente invention, au moins deux sous-cellules voisines sont séparées par une diode tunnel dont la première couche et la seconde couche ne sont en contact avec aucune électrode, lesdites au moins deux sous-cellules voisines formant un ensemble de sous-cellules destinées à être connectées en série.

Un avantage d'une cellule solaire multi-jonctions du type de celle décrite ci-dessus réside dans le fait que chaque sous-cellule peut être associée à deux électrodes permettant de la polariser indépendamment des autres sous-cellules. En outre, les différentes sous-cellules peuvent être polarisées indépendamment les unes des autres et de façon simultanée.

Un autre avantage d'une telle cellule solaire multi-jonctions réside dans le fait qu'elle peut fonctionner soit comme une cellule solaire à deux jonctions monolithique (en mode monolithique), soit comme une cellule solaire à deux jonctions multi-terminale (en mode multi-terminal).

Un autre avantage d'une telle cellule solaire multi-jonctions est lié au fait que le fonctionnement de chacune des sous-cellules peut être optimisé individuellement, et donc le rendement global de la cellule solaire maximisé.

Un autre avantage d'une telle cellule solaire multi-jonctions réside dans le fait qu'elle peut être fabriquée par un procédé de fabrication simple à mettre en oeuvre, de type monolithique.

La présente invention concerne également un procédé de formation d'une cellule solaire, comprenant les étapes suivantes consistant à a) former un empilement d'au moins deux sous-cellules, une diode tunnel, comportant une première et une seconde couches superposées dopées selon des types de conductivités opposés, étant interposée entre deux sous-cellules voisines; puis, dans un ordre quelconque, b) former une première électrode et une deuxième électrode respectivement en contact avec la face de l'empilement destinée à être exposée au rayonnement lumineux et avec la face de l'empilement opposée à ladite face destinée à être exposée au rayonnement lumineux; et c) pour au moins une diode tunnel, former une troisième électrode et une quatrième électrode respectivement en contact électrique avec la première couche et la seconde couche de la diode tunnel.

Selon un mode de réalisation de la présente invention, lors de l'étape c), pour chaque diode tunnel, une troisième électrode et une quatrième électrode, respectivement en contact électrique avec la première couche et la seconde couche de la diode tunnel, sont formées.

Lors de l'étape a), l'empilement d'au moins deux sous-cellules avec interposition d'une diode tunnel peut être formé par croissance par épitaxie.

Le procédé ci-dessus peut comporter en outre, entre les étapes a) et c), une étape de formation, pour au moins une diode tunnel, d'une première ouverture et d'une seconde ouverture de façon à découvrir respectivement une portion de la première couche et une portion de la seconde couche de la diode tunnel.

Selon un mode de réalisation de la présente invention, l'étape de formation, pour au moins une diode tunnel, des première et seconde ouvertures est réalisée avant l'étape b) de formation des première et deuxième électrodes.

Les première et seconde ouvertures peuvent être formées par un procédé de gravure anisotrope, par exemple par gravure par plasma, ou par un procédé de gravure isotrope, par exemple par gravure chimique par voie liquide.

Les première et seconde ouvertures peuvent être formées à partir de la face de l'empilement destinée à être exposée au rayonnement lumineux, dite face avant.

En variante, elles peuvent être formées à partir de la face de l'empilement dite face arrière, opposée à ladite face destinée à être exposée au rayonnement lumineux. Selon une autre variante, elles peuvent être formées à partir de la face avant et à partir de la face arrière.

Un avantage d'un procédé de formation d'une cellule solaire multi-jonctions du type de celui décrit ci-dessus réside dans le fait qu'il est simple à mettre en oeuvre. En effet, un tel procédé utilise des étapes couramment utilisées au cours des procédés de fabrication de composants micro-électroniques.

La présente invention concerne en outre un procédé d'utilisation d'une cellule solaire du type de celle décrite ci-dessus, comprenant les étapes suivantes consistant à a) mesurer le courant délivré par chaque sous-cellule ou ensemble de sous-cellules connectées en série ; b) comparer les courants délivrés par les différentes sous-cellules ou ensembles de sous-cellules ; c) si les courants délivrés par les différentes sous-cellules ou ensembles de sous-cellules sont égaux, connecter la cellule solaire de sorte qu'elle fonctionne en mode monolithique ; c') si les courants délivrés par les différentes sous-cellules ou ensembles de sous-cellules ne sont pas tous égaux entre eux, connecter la cellule solaire de sorte qu'elle fonctionne en mode multi-terminal.

Selon un mode de réalisation de la présente invention, pour chaque diode tunnel dont la première couche et la seconde couche sont respectivement en contact avec une troisième électrode et une quatrième électrode, lors de l'étape c), les troisième et quatrième électrodes ne sont pas connectées et la diode tunnel est électriquement conductrice.

Lors de l'étape c), une différence de potentiel peut être appliquée entre les première et deuxième électrodes de sorte que la puissance délivrée par la cellule solaire soit maximale.

Selon un mode de réalisation de la présente invention, pour chaque diode tunnel dont la première couche et la seconde couche sont respectivement en contact avec une troisième électrode et une quatrième électrode, lors de l'étape c'), une différence de potentiel est appliquée entre les troisième et quatrième électrodes de sorte que le courant traversant la diode tunnel soit minimal.

Selon un mode de réalisation de la présente invention, lors de l'étape c'), pour chaque diode tunnel dont la première couche et la seconde couche sont respectivement en contact avec une troisième électrode et une quatrième électrode, on recherche la différence de potentiel à appliquer entre les troisième et quatrième électrodes pour que le courant traversant la diode tunnel soit minimal.

Selon un mode de réalisation de la présente invention, lors de l'étape c'), pour chaque sous-cellule ou ensemble de sous-cellules connectées en série, on recherche la polarisation optimale de la sous-cellule ou de l'ensemble de sous-cellules pour laquelle la puissance délivrée par la sous-cellule ou par l'ensemble de sous-cellules est maximale. Chaque électrode de la cellule solaire peut alors être polarisée de sorte que chaque sous-cellule ou ensemble de sous-cellules soit polarisé à ladite polarisation optimale.

Le procédé d'utilisation d'une cellule solaire du type de celle décrite ci-dessus peut comporter en outre une étape d) consistant à répéter les étapes a) à c) ou les étapes a) à c'). Ainsi, si l'alignement en courant des sous-cellules est dégradé au cours de l'utilisation de la cellule solaire, par exemple à cause d'une dégradation des caractéristiques d'une des sous-cellules ou à cause d'une dégradation d'un élément externe à la cellule solaire telle qu'une optique de concentration ou à cause d'un spectre solaire réel non conforme au spectre solaire utilisé pour la conception de la cellule solaire, la cellule solaire passe du mode de fonctionnement monolithique au mode de fonctionnement multi-terminal. Il en résulte un rendement optimisé de la cellule solaire.

Selon un mode de réalisation de la présente invention, à chaque répétition de l'étape c'), on peut rechercher à nouveau, pour chaque diode tunnel dont la première couche et la seconde couche sont respectivement en contact avec une troisième électrode et une quatrième électrode, la différence de potentiel à appliquer entre les troisième et quatrième électrodes pour que le courant traversant la diode tunnel soit minimal.

A chaque répétition de l'étape c'), on peut rechercher à nouveau la polarisation optimale de chaque sous-cellule ou ensemble de sous-cellules.

L'étape d) peut être répétée à intervalles de temps réguliers.

Un avantage d'un procédé d'utilisation d'une cellule solaire multi-jonctions du type de celui décrit ci-dessus réside dans le fait que la puissance délivrée par la cellule solaire peut être optimisée même lorsque les sous-cellules ne délivrent pas toutes le même courant. Il en résulte un rendement optimal de la cellule solaire.

Un autre avantage d'un tel procédé d'utilisation d'une cellule solaire multi-jonctions réside dans le fait que si l'alignement en courant des sous-cellules est dégradé, par exemple à cause d'une dégradation des performances d'une des sous-cellules ou pour des raisons externes à la cellule solaire ou à cause d'un spectre solaire réel non conforme au spectre solaire utilisé pour la conception de la cellule solaire, ceci n'impacte pas les autres sous-cellules car les sous-cellules sont alors connectées en mode multi-terminal.

Un autre avantage d'un tel procédé d'utilisation d'une cellule solaire multi-jonctions réside dans le fait qu'il n'est pas nécessaire de fabriquer la cellule solaire de sorte que toutes les sous-cellules délivrent le même courant.

La présente invention divulgue en outre un procédé d'utilisation d'une cellule solaire du type de celle décrite ci-dessus, comprenant les étapes suivantes consistant à a) mesurer le courant délivré par chaque sous-cellule ; b) comparer les courants délivrés par les différentes sous-cellules ; c) si les courants délivrés par les différentes sous-cellules sont égaux, connecter la cellule solaire de sorte qu'elle fonctionne en mode monolithique ; c') si les courants délivrés par les différentes sous-cellules ne sont pas tous égaux entre eux, connecter les sous-cellules voisines qui délivrent le même courant en mode monolithique et connecter les autres sous-cellules en mode multi-terminal.

Il est décrit en outre un dispositif de test d'une cellule solaire du type de celle décrite ci-dessus, comprenant des moyens de mesure ou de détermination du courant délivré par chaque sous-cellule ou ensemble de sous-cellules connectées en série, et des moyens de comparaison des courants délivrés par les différentes sous-cellules ou ensembles de sous-cellules. Des moyens permettent en outre de connecter la cellule solaire de sorte qu'elle fonctionne en mode monolithique si les courants délivrés par les différentes sous-cellules ou ensembles de sous-cellules sont égaux, et de sorte qu'elle fonctionne en mode multi-terminal si les courants délivrés par les différentes sous-cellules ou ensembles de sous-cellules ne sont pas tous égaux entre eux.

Ce dispositif de test comprend en outre des premiers moyens d'analyse destinés à rechercher, pour chaque diode tunnel, la différence de potentiel à appliquer entre les troisième et quatrième électrodes pour que le courant traversant la diode tunnel soit minimal.

Il peut éventuellement comporter en outre des moyens de calcul destinés à calculer la puissance délivrée par chaque sous-cellule ou ensemble de sous-cellules en fonction de sa polarisation.

Des seconds moyens d'analyse peuvent être prévus, pour rechercher, pour chaque sous-cellule ou ensemble de sous-cellules, la polarisation optimale de la sous-cellule ou de l'ensemble de sous-cellules pour laquelle la puissance délivrée par la sous-cellule ou par l'ensemble de sous-cellules est maximale.

Le dispositif de test peut comporter en outre des moyens de calcul ou de détermination du potentiel à appliquer sur chaque électrode de la cellule solaire de sorte que le courant traversant chaque diode tunnel soit minimal et de sorte que la puissance délivrée par chaque sous-cellule ou ensemble de sous-cellules soit maximale.

Le dispositif de test peut comporter un ordinateur ou un calculateur ou un système de mesure permettant de réaliser les calculs ou les mesures de différences de potentiels, et/ou de potentiels et/ou de puissances présentés ci-dessus.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
La figure 1 est une vue en coupe représentant de façon schématique un mode de réalisation d'une cellule solaire à deux jonctions selon l'invention.
La figure 2 est une caractéristique courant-tension usuelle d'une diode tunnel.
Les figures 3A et 3B sont des vues en coupe représentant de façon schématique une cellule solaire à deux jonctions selon l'invention connectée respectivement pour un fonctionnement en mode monolithique et pour un fonctionnement en mode multi-terminal.
La figure 4 est une vue en coupe représentant de façon schématique un mode de réalisation d'une cellule solaire à trois jonctions selon l'invention.
La figure 5 est une vue en coupe représentant de façon schématique une variante d'une cellule solaire à trois jonctions selon l'invention.
La figure 6 est une vue en coupe représentant de façon schématique une variante d'une cellule solaire à deux jonctions selon l'invention.
La figure 7 est un diagramme illustrant un procédé d'utilisation d'une cellule solaire multi-jonctions selon l'invention.
Les figures 8A à 8D sont des vues en coupe représentant de façon schématique des étapes successives d'un procédé de fabrication d'une cellule solaire à deux jonctions selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les inventeurs proposent de réaliser une cellule solaire multi-jonctions selon une intégration dite monolithique et d'utiliser les couches dopées selon des types de conductivité opposés des diodes tunnel disposées entre les différentes sous-cellules, de façon à pouvoir connecter les différentes sous-cellules indépendamment les unes des autres.

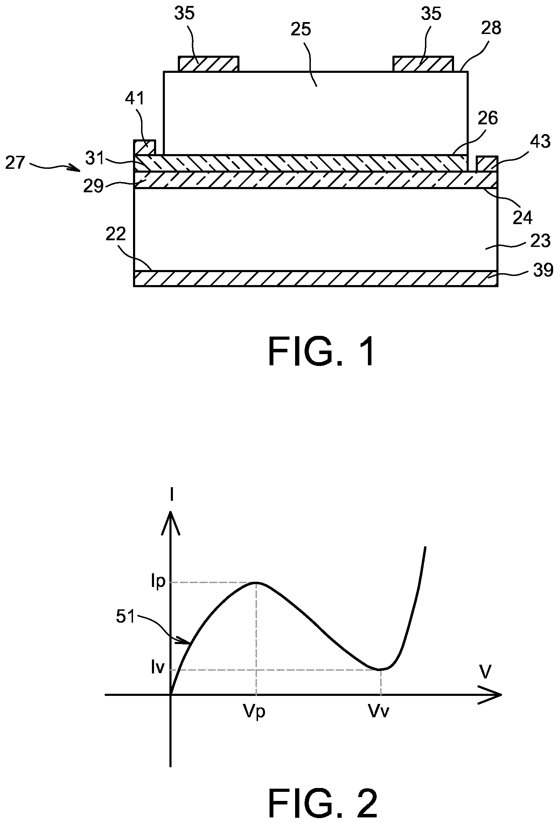

La figure 1 est une vue en coupe représentant de façon schématique un mode de réalisation d'une cellule solaire à deux jonctions selon l'invention.

La cellule solaire comprend un empilement de deux sous-cellules 23 et 25, une diode tunnel 27 étant interposée entre les sous-cellules 23 et 25. Chaque sous-cellule 23, 25 est constituée d'un empilement de couches semi-conductrices formant une jonction PN.

La sous-cellule 23 comprend deux faces principales 22 et 24, et la sous-cellule 25 comprend deux faces principales 26 et 28. La face 22 et la face 28 sont disposées aux extrémités de l'empilement. Dans ce mode de réalisation comme dans tous les modes de réalisation décrits ci-après, la face 28 de la cellule solaire est de préférence la face qui est destinée à être exposée au rayonnement lumineux incident, dite face avant, et la face 22 est opposée à la face destinée à être exposée au rayonnement lumineux, et dite face arrière. Dans ce cas, les sous-cellules 23, 25 sont formées de façon que l'énergie de bande interdite de la sous-cellule 25 soit supérieure à celle de la sous-cellule 23. Le rayonnement incident qui n'est pas absorbé par la sous-cellule 25 est ainsi transmis à la sous-cellule 23.

La diode tunnel 27 comprend au moins un empilement de deux couches semi-conductrices 29 et 31 superposées très fortement dopées, par exemple selon un niveau de dopage supérieur à 10¹⁹ cm⁻³ et selon des types de conductivité opposés, formant une jonction tunnel. La diode tunnel 27 est réalisée de façon à avoir un facteur de transmission optique élevé, pour minimiser les pertes de courant dues à l'absorption du rayonnement par les couches de la diode tunnel. Dans le cas où chaque sous-cellule 23, 25 comprend un empilement de couches semi-conductrices de type P recouvertes de couches semi-conductrices de type N, les couches 29 et 31 de la diode tunnel 27 sont respectivement de type N et de type P.

A titre d'exemple, les couches 29 et 31 de la diode tunnel 27 sont en GaAs et ont une épaisseur comprise entre 5 et 30 nm, par exemple de l'ordre de 15 nm. La couche 29 est par exemple dopée de type N, par exemple selon un niveau de dopage compris entre 1.10¹⁹ et 8.10¹⁹ cm⁻³, par exemple de l'ordre de 3.10¹⁹ cm⁻³. La couche 31 est alors dopée de type P, par exemple selon un niveau de dopage compris entre 1.10¹⁹ et 8.10¹⁹ cm⁻³, par exemple de l'ordre de 5.10¹⁹ cm⁻³.

Une électrode (ou contact conducteur) 35 est en contact avec la face 28 et une électrode (ou contact conducteur) 39 est en contact avec la face 22. Les contacts 35 et 39 sont destinés à polariser respectivement les faces 28 et 22 de la cellule solaire. En outre, le contact 35 constitue une première électrode pour polariser la sous-cellule 25, et le contact 39 constitue une première électrode pour polariser la sous-cellule 23.

Le contact 35 peut être formé d'une couche conductrice continue recouvrant entièrement la face 28. Dans ce cas, il est de préférence en un matériau conducteur optiquement transparent. Selon une alternative, le contact 35 recouvre seulement en partie la face 28. Il en résulte une meilleure absorption du rayonnement lumineux par la sous-cellule 25 par rapport au cas où le contact 35 est formé d'une couche conductrice continue recouvrant entièrement la face 28. Dans le cas où le contact 35 recouvre seulement en partie la face 28, il peut être en un matériau conducteur non transparent optiquement. Le contact 35 peut être formé de pistes conductrices disposées à distance les unes des autres, comme cela est représenté en figure 1, par exemple de lignes conductrices parallèles les unes aux autres. Avantageusement, le contact 39 est formé d'une couche conductrice continue recouvrant entièrement la face 22. Il en résulte un meilleur contact avec la sous-cellule 23 et donc une optimisation du courant collecté.

Les inventeurs proposent d'utiliser les couches 31 et 29 de la diode tunnel 27 comme couches électriquement conductrices afin de polariser respectivement la sous-cellule 25 et la sous-cellule 23.

Une électrode (ou contact conducteur) 41 est en contact avec la couche 31 de la diode tunnel 27 et une électrode (ou contact conducteur) 43 est en contact avec la couche 29 de la diode tunnel 27. Chacun des contacts 41 et 43 est isolé électriquement des autres couches de l'empilement constituant la cellule solaire. Les contacts 41 et 43 sont par exemple disposés du côté de la face 28 ou, dit autrement, en contact avec la face supérieure de la couche 31, 29 correspondante. Par définition, la face supérieure de la couche 31 correspond à la face en contact avec la sous-cellule 25 et la face supérieure de la couche 29 correspond à la face en contact avec la couche 31. Chacune des couches 31 et 29 comporte également une face inférieure opposée à la face supérieure correspondante telle que définie ci-dessus. Les contacts 41 et 43 sont destinés à polariser respectivement les couches 31 et 29 de la diode tunnel 27.

Ainsi, la sous-cellule 25 peut être polarisée par les électrodes 35 et 41, et la sous-cellule 23 peut être polarisée par les électrodes 39 et 43.

Les contacts 41 et 43 sont par exemple disposés aux extrémités latérales de la cellule solaire comme cela est représenté en figure 1. La couche 31 de la diode tunnel 27 recouvre de préférence entièrement la face 26 de la sous-cellule 25 afin de permettre que l'ensemble des porteurs générés par la sous-cellule 25 soient collectés par l'électrode 41. Les couches 31 et 29 de la diode tunnel très fortement dopées permettent un mécanisme de conduction latéral des porteurs. Ainsi, quelle que soit la localisation de la collection d'un porteur dans la couche 31, celui-ci génèrera un courant qui, par conduction latérale, pourra être collecté par l'électrode 41.

Les contacts 35, 39, 41 et 43 sont de préférence réalisés en un alliage de matériaux métalliques. Eventuellement, le contact 35 peut être réalisé en un matériau conducteur optiquement transparent, par exemple en ITO (« Indium Tin Oxide », oxyde d'indium-étain), et/ou le contact 39 peut être réalisé en un matériau semi-conducteur dopé.

Selon une variante de la cellule solaire illustrée en figure 1, la diode tunnel 27 peut comprendre en outre des couches barrière conductrices disposées de part et d'autre de la jonction tunnel constituée des couches 29 et 31. La couche barrière disposée entre la sous-cellule 25 et la couche 31 est dite couche barrière supérieure, et la couche barrière disposée entre la sous-cellule 23 et la couche 29 est dite couche barrière inférieure. Ces couches barrière permettent d'éviter la diffusion des éléments dopants de la jonction tunnel vers les sous-cellules 23 et 25. Les électrodes 41 et 43 sont de préférence en contact direct respectivement avec les couches 31 et 29 de la jonction tunnel. Eventuellement, les couches barrière étant conductrices, les électrodes 41 et 43 peuvent être en contact direct respectivement avec les couches barrière supérieure et inférieure. Néanmoins, selon les inventeurs, les contacts électriques sont meilleurs si chacune des électrodes 41, 43 est en contact direct avec la couche 31, 29 correspondante plutôt qu'en contact direct avec la couche barrière correspondante. Eventuellement, une des électrodes 41, 43 peut être en contact direct avec la couche 31, 29 correspondante et l'autre électrode peut être en contact direct avec la couche barrière correspondante.

Un avantage d'une cellule solaire du type de celle illustrée en figure 1 réside dans le fait que chaque sous-cellule est associée à deux électrodes qui lui sont dédiées, permettant de la polariser indépendamment de l'autre sous-cellule. En outre, les deux sous-cellules peuvent être polarisées indépendamment l'une de l'autre et de façon simultanée.

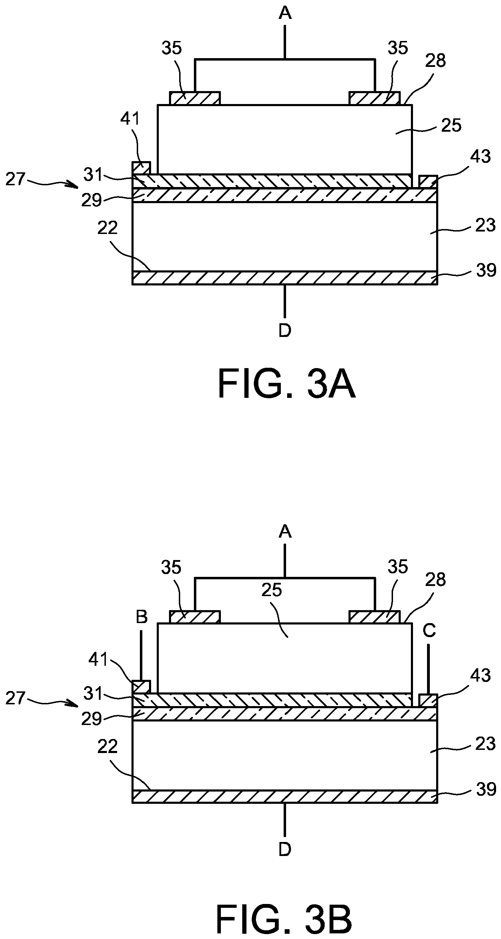

Le fonctionnement d'une cellule solaire du type de celle illustrée en figure 1 est décrit ci-après en relation avec les figures 2 et 3A-3B.

La figure 2 illustre une caractéristique courant-tension I(V) usuelle représentant le courant I traversant une diode tunnel en fonction de la tension V à ses bornes. La caractéristique I(V) comprend un pic de courant de valeur Ip pour la polarisation Vp et un minimum de courant Iv pour la polarisation Vv. Les points Ip(Vp) et Iv(Vv) sont notamment déterminés par les matériaux des couches N et P fortement dopées de la diode tunnel, par leur niveau de dopage et par leur épaisseur. De préférence, la cellule solaire illustrée en figure 1 est fabriquée de sorte que le courant Ip de la diode tunnel 27 soit supérieur au courant I délivré par la cellule solaire dans ses conditions nominales de fonctionnement, et traversant la diode tunnel. Le régime d'utilisation usuelle de la diode tunnel correspond à la portion 51 de la caractéristique I(V), c'est-à-dire aux points de courant I inférieur à Ip et de tension V inférieure à Vp.

Pour trouver le point de polarisation Vv de la diode tunnel, on applique une différence de potentiel entre les électrodes 41 et 43 de la diode tunnel. On fait varier cette différence de potentiel jusqu'à trouver la polarisation Vv pour laquelle le courant traversant la diode tunnel est minimal (égal à Iv).

Pour une diode tunnel 27 comprenant une couche 29 en GaAs, d'une épaisseur de l'ordre de 20 nm, dopée de type N selon un niveau de dopage de l'ordre de 3.10¹⁹ cm⁻³, et une couche 31 en GaAs, d'une épaisseur de l'ordre de 20 nm, dopée de type P selon un niveau de dopage de l'ordre de 5.10¹⁹ cm⁻³, la polarisation Vv est par exemple de l'ordre de 0,8 V.

La figure 3A est une vue en coupe illustrant de façon schématique une cellule solaire à deux jonctions du type de celle décrite en relation avec la figure 1 dans le cas où les deux sous-cellules 23, 25 sont connectées en série. On parle dans ce cas d'un fonctionnement en mode « monolithique ».

Dans le mode de fonctionnement monolithique, une différence de potentiel est appliquée entre les électrodes 35 (A) et 39 (D) respectivement en contact avec les faces 28 et 22. Les électrodes 41 et 43 respectivement en contact avec les couches 31 et 29 de la diode tunnel 27 ne sont pas connectées. Les sous-cellules 23, 25 et la diode tunnel 27 sont connectées en série. La diode tunnel 27 est traversée par un courant correspondant au minimum des courants délivrés par les sous-cellules 23 et 25. Le point de fonctionnement de la diode tunnel est situé dans la portion 51 de la caractéristique I(V). La diode tunnel fonctionne alors dans un régime dit linéaire et « passant ». Elle est conductrice et se comporte comme une résistance de valeur très faible. La diode tunnel 27 permet d'assurer le passage des porteurs entre les sous-cellules 23 et 25.

La figure 3B est une vue en coupe illustrant de façon schématique une cellule solaire à deux jonctions du type de celle décrite en relation avec la figure 1 dans le cas où les deux sous-cellules 23, 25 sont connectées indépendamment l'une de l'autre.

On parle dans ce cas d'un fonctionnement en mode « multi-terminal ».

Dans le mode de fonctionnement multi-terminal, une différence de potentiel V_{AB} est appliquée entre les électrodes 35 (A) et 41 (B) pour polariser la sous-cellule 25 et une différence de potentiel V_{CD} est appliquée entre les électrodes 43 (C) et 39 (D) pour polariser la sous-cellule 23. Les couches 31 et 29 de la diode tunnel, sur lesquelles sont respectivement pris les contacts B et C, étant superposées sans isolant intermédiaire, il convient de minimiser la conduction de courant entre les couches 31 et 29 de la diode tunnel.

Pour cela, une différence de potentiel V_{BC} bien choisie est préalablement appliquée entre les électrodes 41 et 43, c'est-à-dire aux bornes de la diode tunnel. La polarisation V_{BC} est choisie proche de la polarisation Vv pour laquelle le courant I traversant la diode tunnel est minimal (égal à la valeur Iv). La diode tunnel fonctionne alors dans un régime dit « bloquant ». La diode tunnel 27 n'est plus conductrice mais présente un caractère quasi-isolant. Les sous-cellules 23 et 25 fonctionnent alors indépendamment l'une de l'autre.

En outre, pour optimiser la puissance délivrée par la cellule solaire, on peut rechercher le point de polarisation optimal de chaque sous-cellule, c'est-à-dire la différence de potentiel Vmax à appliquer entre les électrodes associées à chaque sous-cellule de sorte que la puissance délivrée par chaque sous-cellule soit maximale.

Pour trouver le point de polarisation optimal de la sous-cellule 25, on applique une différence de potentiel V_{AB} entre les électrodes 35 et 41. On fait varier la différence de potentiel V_{AB} et on mesure le courant délivré par la sous-cellule en fonction de cette différence de potentiel. A partir de ces mesures, on calcule la puissance délivrée par la sous-cellule en fonction de la différence de potentiel V_{AB}. La différence de potentiel V_{AB} pour laquelle la puissance délivrée par la sous-cellule 25 est maximale correspond à la polarisation optimale Vmax de la sous-cellule 25. Pour trouver le point de polarisation optimal de la sous-cellule 23, on applique une différence de potentiel V_{CD} entre les électrodes 43 et 39 et on procède de façon similaire.

Un avantage d'une cellule solaire du type de celle illustrée en figure 1 réside dans le fait qu'elle peut fonctionner soit comme une cellule solaire à deux jonctions monolithique (en mode monolithique, décrit ci-dessus en relation avec la figure 3A), soit comme une cellule solaire à deux jonctions multi-terminale (en mode multi-terminal, décrit ci-dessus en relation avec la figure 3B).

Un autre avantage d'une telle cellule solaire est lié au fait que le fonctionnement de chacune des sous-cellules peut être optimisé individuellement, et donc le rendement global de la cellule solaire maximisé.

Un autre avantage d'une telle cellule solaire réside dans le fait qu'elle peut être fabriquée par un procédé de fabrication simple à mettre en oeuvre, de type monolithique.

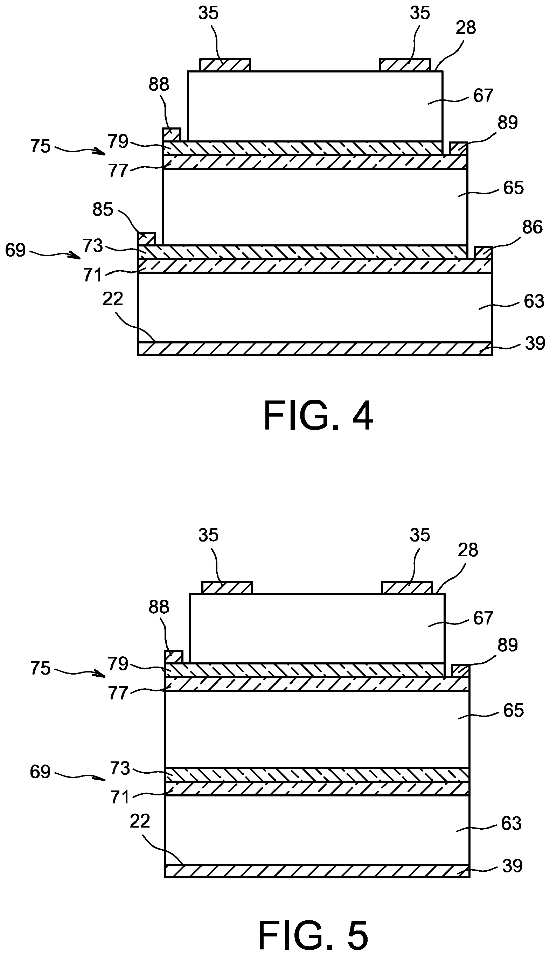

La figure 4 est une vue en coupe représentant de façon schématique une cellule solaire à trois jonctions selon l'invention.

La cellule solaire comprend un empilement de trois sous-cellules 63, 65 et 67, une diode tunnel 69, 75 étant respectivement interposée entre les sous-cellules 63 et 65 et entre les sous-cellules 65 et 67. Chaque diode tunnel 69, 75 comprend un empilement de deux couches semi-conductrices superposées, 71 et 73, 77 et 79, fortement dopées selon des types de conductivité opposés.

Une électrode 35 est en contact avec la face 28 de la cellule solaire et, de préférence, ne recouvre pas entièrement cette face. Une électrode 39 est en contact avec la face 22 de la cellule solaire et, de préférence, recouvre entièrement cette face.

Des électrodes 85 et 86 sont respectivement en contact avec les couches 73 et 71 de la diode tunnel 69, et sont isolées électriquement des autres couches de l'empilement. De même, des électrodes 88 et 89 sont respectivement en contact avec les couches 79 et 77 de la diode tunnel 75, et sont isolées électriquement des autres couches de l'empilement. Les électrodes 85 et 86 sont destinées à polariser respectivement les couches 73 et 71 de la diode tunnel 69, et les électrodes 88 et 89 sont destinées à polariser respectivement les couches 79 et 77 de la diode tunnel 75.

La sous-cellule 67 est destinée à être polarisée par les électrodes 35 et 88. La sous-cellule 65 est destinée à être polarisée par les électrodes 89 et 85. La sous-cellule 63 est destinée à être polarisée par les électrodes 39 et 86.

Comme la cellule solaire à deux jonctions illustrée en figure 1, la cellule solaire à trois jonctions illustrée en figure 4 peut fonctionner soit en mode monolithique soit en mode multi-terminal.

En mode monolithique, une différence de potentiel est appliquée entre les électrodes 35 et 39 respectivement en contact avec les faces 28 et 22. Les électrodes 85, 86, 88, 89 ne sont pas connectées. Les diodes tunnel 69 et 75 sont électriquement conductrices, et les sous-cellules 63, 65, 67 et les diodes tunnel 69, 75 sont connectées en série.

En mode multi-terminal, une différence de potentiel sensiblement égale à la polarisation Vv de la diode tunnel 75 est appliquée entre les contacts 88 et 89 et une différence de potentiel sensiblement égale à la polarisation Vv de la diode tunnel 69 est appliquée entre les contacts 85 et 86, de sorte que le courant traversant les diodes tunnel 75 et 69 soit minimal. Les sous-cellules 63, 65, 67 sont connectées indépendamment les unes des autres par application d'une différence de potentiel entre les électrodes qui leur sont associées. Les trois sous-cellules peuvent être connectées indépendamment les unes des autres et de façon simultanée. On peut également par exemple connecter une seule des trois sous-cellules à la fois, ou deux des trois sous-cellules simultanément.

La figure 5 est une vue en coupe représentant de façon schématique une variante d'une cellule solaire à trois jonctions selon l'invention. Les éléments communs avec ceux de la figure 4 sont désignés par les mêmes références.

Par rapport à la cellule solaire illustrée en figure 4, la cellule solaire illustrée en figure 5 ne comprend pas de contacts destinés à polariser les couches 71 et 73 de la diode tunnel 69. La diode tunnel 69 est électriquement conductrice et les sous-cellules 63 et 65 sont connectées en série. Ce mode de réalisation peut être choisi lorsque l'on prévoit que les sous-cellules 63 et 65 seront alignées en courant.

La sous-cellule 67 peut être soit connectée en série avec l'ensemble des sous-cellules 63 et 65, soit connectée indépendamment de l'ensemble des sous-cellules 63 et 65 grâce aux contacts 88 et 89 de polarisation des couches 79 et 77 de la diode tunnel 75.

Pour connecter la sous-cellule 67 en série avec l'ensemble des sous-cellules 63 et 65, une différence de potentiel est appliquée entre les électrodes 35 et 39, et les électrodes 88 et 89 ne sont pas connectées. La diode tunnel 75 est alors électriquement conductrice. La cellule solaire fonctionne en mode monolithique.

Pour connecter la sous-cellule 67 indépendamment de l'ensemble des sous-cellules 63 et 65, une différence de potentiel sensiblement égale à la polarisation Vv de la diode tunnel 75 est appliquée entre les électrodes 88 et 89 de façon que le courant traversant la diode tunnel 75 soit minimal. La sous-cellule 67 est polarisée par application d'une différence de potentiel entre les électrodes 35 et 88, et l'ensemble des sous-cellules 63 et 65 est polarisé par application d'une différence de potentiel entre les électrodes 89 et 39. La cellule solaire fonctionne selon un mode mixte entre les modes monolithique et multi-terminal. Eventuellement, seul l'ensemble des sous-cellules 63 et 65 peut être polarisé ou seule la sous-cellule 67 peut être polarisée.

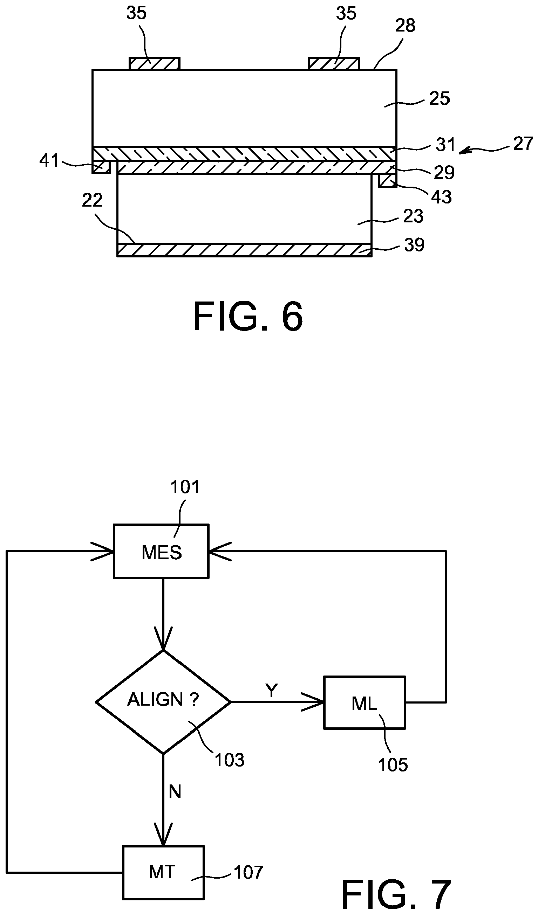

La figure 6 est une vue en coupe représentant de façon schématique une variante d'une cellule solaire à deux jonctions selon l'invention. Les éléments communs avec ceux de la figure 1 sont désignés par les mêmes références.

Les électrodes 41 et 43, respectivement en contact avec les couches 31 et 29 de la diode tunnel 27, ne sont pas disposées du côté de la face 28 destinée à être exposée au rayonnement lumineux comme dans la cellule solaire illustrée en figure 1, mais du côté de la face 22. Des vias conducteurs non représentés peuvent également être prévus à travers l'empilement des sous-cellules pour ramener les connexions de l'électrode 35 vers la face 22 de la cellule solaire.

Une cellule solaire du type de celles illustrées en figures 1 et 4-6 peut comprendre un empilement de n sous-cellules (n étant un nombre entier supérieur ou égal à 2), une diode tunnel 27, comportant deux couches superposées 29, 31 fortement dopées selon des types de conductivités opposés, étant interposée entre deux sous-cellules voisines. Dans une telle cellule solaire, deux électrodes 35, 39 sont respectivement en contact avec les faces 28, 22 disposées aux extrémités de l'empilement. Pour au moins une diode tunnel 27, deux autres électrodes 41 et 43 sont respectivement en contact avec les couches 31 et 29 de la diode tunnel. Les électrodes 41, 43 ne sont pas en contact direct avec les sous-cellules. Les électrodes 41 et 43 sont destinées à polariser respectivement les couches 31 et 29 des diodes tunnel 27.

Selon un mode de réalisation, chaque diode tunnel est associée à deux électrodes 41, 43 permettant de polariser chaque sous-cellule indépendamment des autres sous-cellules.

La sous-cellule du niveau supérieur de l'empilement (niveau n) est destinée à être polarisée par l'électrode 35 et par l'électrode 41 en contact avec la couche supérieure 31 de la diode tunnel séparant cette sous-cellule de la sous-cellule de niveau n-1. La sous-cellule du niveau inférieur de l'empilement (niveau 1) est destinée à être polarisée par l'électrode 39 et par l'électrode 43 en contact avec la couche inférieure 29 de la diode tunnel séparant cette sous-cellule de la sous-cellule de niveau 2.

Chaque sous-cellule de niveau i compris entre 2 et n-1 est destinée à être polarisée par l'électrode 43 en contact avec la couche inférieure 29 de la diode tunnel séparant la sous-cellule de niveau i de la sous-cellule de niveau i+1, et par l'électrode 41 en contact avec la couche supérieure 31 de la diode tunnel séparant la sous-cellule de niveau i de la sous-cellule de niveau i-1.

Ainsi, chaque sous-cellule peut être associée à deux électrodes permettant de la polariser indépendamment des autres sous-cellules, pour un fonctionnement en mode multi-terminal. Les différentes sous-cellules peuvent être connectées indépendamment les unes des autres de façon simultanée. Par application d'une différence de potentiel sensiblement égale à la polarisation Vv de la diode tunnel entre les contacts 41,43, le courant traversant chaque diode tunnel est minimisé de façon à permettre un fonctionnement de chaque sous-cellule indépendant de celui des autres sous-cellules.

En variante, la cellule solaire peut comprendre des diodes tunnel qui ne sont pas associées à des contacts de polarisation 41, 43. Ces diodes tunnel sont alors électriquement conductrices. On obtient ainsi des ensembles de sous-cellules connectées en série.

La figure 7 est un diagramme illustrant un procédé d'utilisation d'une cellule solaire multi-jonctions selon l'invention. Dans la description de la figure 7 ci-dessous, on entend également par le terme « sous-cellule » un ensemble de sous-cellules connectées en série (tel que par exemple l'ensemble des sous-cellules 63 et 65 de la cellule solaire illustrée en figure 5).

On mesure le courant délivré par chaque sous-cellule, indépendamment des autres sous-cellules (« MES », étape 101). On connecte les sous-cellules les unes après les autres pour un même rayonnement incident. Pour les différentes sous-cellules, on applique la même différence de potentiel entre les électrodes qui leur sont associées pour réaliser la mesure de courant.

On compare les valeurs obtenues du courant délivré par les différentes sous-cellules (« ALIGN ? », étape 103).

Si les courants délivrés par les différentes sous-cellules sont tous égaux entre eux, on dit que les sous-cellules sont alignées en courant. On connecte alors la cellule solaire multi-jonctions de façon qu'elle fonctionne en mode monolithique («ML », étape 105).

Pour cela, pour chaque diode tunnel 27 associée à des électrodes 41 et 43 respectivement en contact avec les couches 31 et 29, les électrodes 41 et 43 ne sont pas connectées et les diodes tunnel sont électriquement conductrices. Une différence de potentiel est appliquée entre les électrodes 35 et 39 respectivement en contact avec les faces 28 et 22 de la cellule solaire. Les sous-cellules et les diodes tunnels sont connectées en série. Avantageusement, la différence de potentiel appliquée entre les électrodes 35 et 39 est choisie de façon à maximiser la puissance délivrée par la cellule solaire multi-jonctions.

Si les courants délivrés par les différentes sous-cellules ne sont pas tous égaux entre eux, les sous-cellules ne sont pas alignées en courant. On connecte alors la cellule solaire multi-jonctions de façon qu'elle fonctionne en mode multi-terminal (« MT », étape 107). Pour cela, pour chaque diode tunnel 27 associée à des électrodes 41 et 43, une différence de potentiel sensiblement égale à la polarisation Vv de la diode tunnel est appliquée entre les électrodes 41 et 43 de sorte que le courant traversant les diodes tunnel soit minimal. Une différence de potentiel est appliquée entre les électrodes associées à chaque sous-cellule.

On peut rechercher ici le point de polarisation Vv de chaque diode tunnel et le point de polarisation optimal Vmax de chaque sous-cellule pour lequel la puissance délivrée par la sous-cellule est maximale, comme expliqué ci-dessus en relation avec les figures 2, 3A et 3B.

Avantageusement, pour maximiser la puissance délivrée par la cellule solaire, on polarise chaque électrode de la cellule solaire de sorte que la différence de potentiel entre les électrodes 41, 43 de chaque diode tunnel soit sensiblement égale à la polarisation Vv et de sorte que la différence de potentiel entre les électrodes associées à chaque sous-cellule soit sensiblement égale à la polarisation optimale Vmax.

Dans le cas de la variante illustrée en figure 5, la cellule solaire comprend des diodes tunnel qui ne sont pas associées à des contacts de polarisation 41, 43 et qui sont électriquement conductrices. En mode multi-terminal, chaque ensemble de sous-cellules connectées en série est également avantageusement polarisé de sorte qu'il délivre une puissance maximale.

Un avantage d'un tel procédé d'utilisation d'une cellule solaire multi-jonctions réside dans le fait que la puissance délivrée par la cellule solaire peut être optimisée même lorsque les sous-cellules ne délivrent pas toutes le même courant.

Un autre avantage d'un tel procédé d'utilisation d'une cellule solaire multi-jonctions réside dans le fait que si une des sous-cellules ou un élément externe tel qu'une optique de concentration présente une dégradation de sa performance, ceci n'impacte pas les performances de la cellule solaire car les sous-cellules sont alors connectées en mode multi-terminal.

Un autre avantage d'un tel procédé d'utilisation d'une cellule solaire multi-jonctions réside dans le fait qu'il n'est pas nécessaire de fabriquer la cellule solaire de sorte que toutes les sous-cellules délivrent le même courant. Il en résulte un procédé de fabrication plus simple d'une telle cellule solaire.

Un mode de réalisation d'un procédé d'utilisation d'une cellule solaire multi-jonctions tel que celui illustré en figure 7 consiste à répéter, par exemple à intervalles de temps réguliers, les étapes 101 et 103 de vérification de l'alignement en courant des différentes sous-cellules, puis l'étape 105 de connexion de la cellule solaire en mode monolithique ou l'étape 107 de connexion de la cellule solaire en mode multi-terminal. Ainsi, si les performances d'une ou plusieurs sous-cellules sont dégradées au cours de l'utilisation de la cellule solaire, ou si les propriétés de l'optique de concentration se sont dégradées sur une partie du spectre solaire, ou si le spectre solaire réel est non conforme au spectre solaire utilisé pour la conception de la cellule solaire, entraînant un désalignement en courant des sous-cellules, la cellule solaire passe du mode de fonctionnement monolithique au mode de fonctionnement multi-terminal. Il en résulte un rendement optimisé de la cellule solaire.

A chaque répétition de l'étape 107, on peut rechercher à nouveau le point de polarisation Vv de chaque diode tunnel et le point de polarisation optimal Vmax de chaque sous-cellule.

Une variante d'un procédé d'utilisation d'une cellule solaire multi-jonctions du type de celui illustré en figure 7 consiste à utiliser un mode de fonctionnement mixte de la cellule solaire entre les modes monolithique et multi-terminal. Après l'étape 103 de comparaison des courants délivrés par les différentes sous-cellules, si les courants délivrés par les différentes sous-cellules ne sont pas tous égaux entre eux, les sous-cellules voisines de l'empilement qui sont alignées en courant sont connectées en série (mode monolithique), et les sous-cellules qui délivrent un courant inférieur au courant délivré par les autres sous-cellules sont connectées de façon indépendante, en mode multi-terminal.

On décrit ci-dessous un dispositif de test d'une cellule solaire multi-jonctions permettant de mettre en oeuvre le procédé d'utilisation décrit ci-dessus en relation avec la figure 7. Ici encore, comme dans la description de la figure 7, le terme « sous-cellule » désigne également un ensemble de sous-cellules connectées en série.

Le dispositif de test comprend des moyens de mesure de courant, permettant de mesurer le courant délivré par chaque sous-cellule en fonction de la différence de potentiel appliquée entre les électrodes qui lui sont associées. Ces moyens de mesure de courant peuvent être reliés à des moyens de comparaison des courants délivrés par les différentes sous-cellules.

Des moyens permettent en outre de connecter la cellule solaire de sorte qu'elle fonctionne en mode monolithique si les courants délivrés par les différentes sous-cellules sont égaux, et de sorte qu'elle fonctionne en mode multi-terminal si les courants délivrés par les différentes sous-cellules ne sont pas tous égaux entre eux.

Les moyens de mesure de courant ci-dessus peuvent permettre en outre de mesurer le courant traversant chaque diode tunnel 27 en fonction de la différence de potentiel appliquée entre les électrodes 41, 43 de la diode tunnel.

Des moyens d'analyse permettent, en fonction de ces mesures de courant, de rechercher, pour chaque diode tunnel, la différence de potentiel Vv à appliquer entre les électrodes 41, 43 pour que le courant traversant la diode tunnel soit minimal.

Des moyens de calcul permettent de calculer la puissance délivrée par chaque sous-cellule en fonction de sa polarisation, à partir de mesures du courant délivré par la sous-cellule en fonction de sa polarisation.

Des moyens, par exemple les moyens d'analyse ci-dessus, permettent en outre de rechercher la polarisation optimale Vmax de chaque sous-cellule pour laquelle la puissance délivrée par la sous-cellule est maximale, à partir des calculs de la puissance délivrée par chaque sous-cellule en fonction de sa polarisation.

Des moyens peuvent être prévus pour calculer le potentiel à appliquer sur chaque électrode de la cellule solaire de sorte que la différence de potentiel entre les électrodes 41, 43 de chaque diode tunnel soit sensiblement égale à la polarisation Vv de la diode tunnel et de sorte que la différence de potentiel entre les électrodes associées à chaque sous-cellule soit sensiblement égale à la polarisation optimale Vmax de la sous-cellule.

Le dispositif de test peut comporter un ordinateur ou un calculateur ou un système de mesure permettant de réaliser les calculs ou mesures de courants, et/ou de différences de potentiels, et/ou de potentiels et/ou de puissances présentés ci-dessus.

Un procédé pouvant être mis en oeuvre pour réaliser une cellule solaire multi-jonctions du type de celle illustrée en figure 1 est décrit ci-dessous.

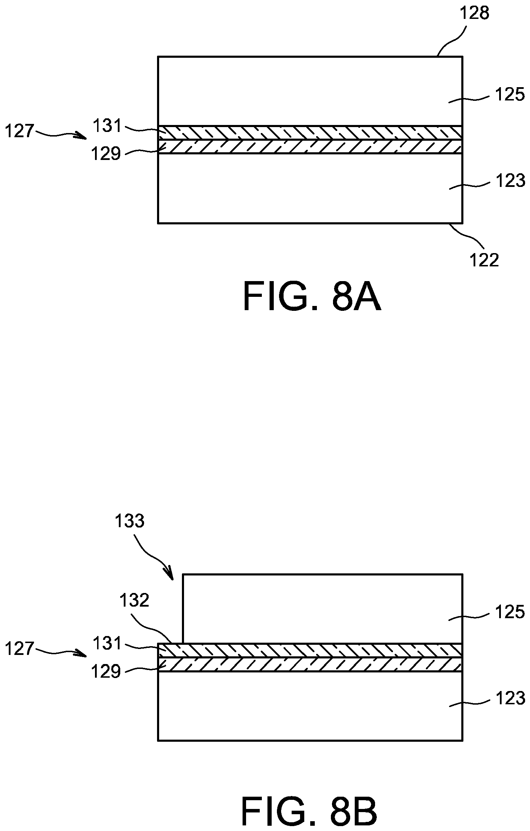

Les figures 8A-8D sont des vues en coupe représentant de façon schématique des étapes successives d'un procédé de fabrication d'une cellule solaire à deux jonctions selon l'invention. Pour des raisons de simplification, le procédé est décrit dans le cadre particulier d'une cellule solaire à deux jonctions. Bien entendu, un tel procédé de fabrication peut être utilisé pour former une cellule solaire à n jonctions (n étant un nombre entier supérieur ou égal à 2), une diode tunnel étant interposée entre deux sous-cellules voisines.

La figure 8A représente un empilement de deux sous-cellules 123 et 125, une diode tunnel 127 étant interposée entre les sous-cellules 123 et 125. Chaque sous-cellule 123, 125 est constituée d'un empilement de différentes couches semi-conductrices formant une jonction PN. La diode tunnel 127 comprend une jonction tunnel constituée de deux couches semi-conductrices 129 et 131 superposées, très fortement dopées selon des types de conductivité opposés. La face 128 de l'empilement est par exemple destinée à être exposée au rayonnement lumineux, et la face 122 de l'empilement est opposée à cette face.

Les différentes couches de l'empilement de la sous-cellule 123, de la diode tunnel 127 et de la sous-cellule 125 ont par exemple été formées successivement par croissance par épitaxie. La couche inférieure de la sous-cellule 123 a par exemple servi de substrat pour la croissance par épitaxie. Eventuellement, des couches de l'empilement ont pu être formées par des procédés de report de couches minces sur un substrat receveur.

La figure 8B illustre la formation d'une ouverture 133 dans la sous-cellule 125, de façon à découvrir une portion 132 de la surface supérieure de la couche 131 de la diode tunnel 127. Pour cela, les portions de la sous-cellule 125 qu'on ne veut pas éliminer sont préalablement protégées. L'ouverture 133 est ensuite formée par un procédé de gravure, par exemple par un procédé de gravure anisotrope, par exemple par gravure par plasma. L'ouverture 133 est par exemple formée au bord de la cellule solaire en cours de formation.

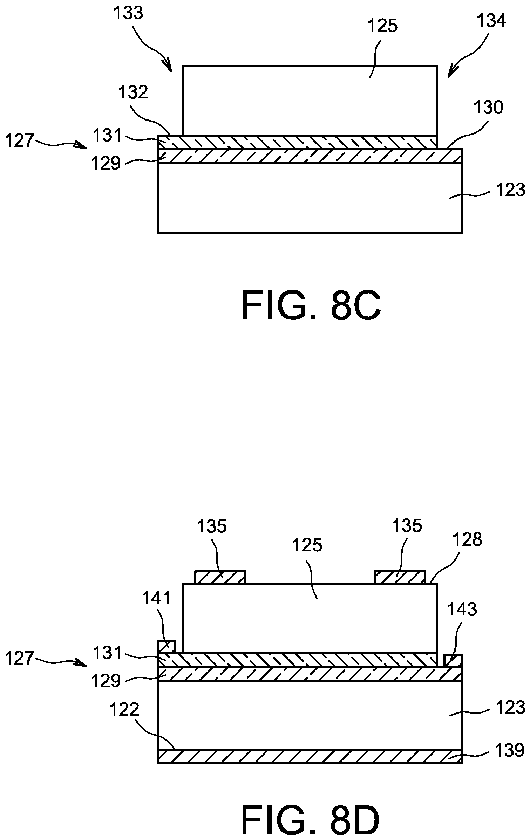

La figure 8C illustre la formation d'une autre ouverture 134 dans la sous-cellule 125 et dans la couche 131 de la diode tunnel 127, de façon à découvrir une portion 130 de la surface supérieure de la couche 129 de la diode tunnel 127. Pour cela, les portions de la sous-cellule 125 et de la couche 131 qu'on ne veut pas éliminer sont préalablement protégées. L'ouverture 134 est ensuite formée par un procédé de gravure, par exemple par un procédé de gravure anisotrope. L'ouverture 134 est par exemple formée au bord de la cellule solaire en cours de formation, à distance de l'ouverture 133.

La figure 8D illustre la formation de contacts conducteurs destinés à polariser la cellule solaire.

Un contact conducteur (ou électrode) 135 est formé sur la face 128 de l'empilement, de préférence de façon à recouvrir seulement en partie la face 128. Pour cela, une couche conductrice, par exemple en un matériau conducteur ou en un matériau semi-conducteur dopé, est formée sur la face 128. Des motifs sont ensuite formés dans la couche conductrice, par exemple par photolithographie puis gravure, de façon à définir des pistes conductrices disposées à distance les unes des autres. Le contact 135 est par exemple formé de lignes conductrices parallèles les unes aux autres.

Un contact conducteur (ou électrode) 139 est formé sur la face 122 de l'empilement, de préférence de façon à recouvrir entièrement la face 122. Pour cela, une couche conductrice continue, par exemple en un matériau conducteur ou en un matériau semi-conducteur dopé, est formée sur la face 122, par exemple en même temps que la couche conductrice du contact 135.

Les contacts 135 et 139 sont destinés à polariser respectivement les faces 128 et 122 de la cellule solaire.

Un contact conducteur (ou électrode) 141 est formé sur la portion découverte 132 de la couche 131 de la diode tunnel 127. Le contact 141 est formé à distance de la sous-cellule 125. Un contact conducteur (ou électrode) 143 est formé sur la portion découverte 130 de la couche 129 de la diode tunnel 127. Le contact 143 est formé à distance de la sous-cellule 125 et de la couche 131 de la diode tunnel. Préalablement à la formation des contacts 141 et 143, les bords des ouvertures 133 et 134 sont par exemple revêtus d'un matériau isolant destiné à isoler le contact 141 de la sous-cellule 125 et le contact 143 de la sous-cellule 125 et de la couche 131. Les contacts 141 et 143 sont destinés à polariser respectivement les couches 131 et 129 de la diode tunnel 127.

On obtient ainsi une cellule solaire à deux jonctions du type de celle illustrée en figure 1.

Un avantage d'un procédé de fabrication d'une cellule solaire multi-jonctions du type de celui décrit en relation avec les figures 8A-8D réside dans le fait qu'il est simple à mettre en oeuvre. En effet, un tel procédé utilise des étapes couramment utilisées au cours des procédés de fabrication de composants micro-électroniques.

Selon une variante du procédé illustré en figures 8A-8D, l'ordre des étapes illustrées respectivement en figures 8B et 8C peut être inversé.

Selon une autre variante du procédé illustré en figures 8A-8D, les ouvertures 133 et 134 sont formées à partir de la face 122, et non pas à partir de la face 128. Dans ce cas, la formation de l'ouverture 133 permet par exemple de découvrir une portion de la surface inférieure de la couche 131 de la diode tunnel 127, et la formation de l'ouverture 134 permet de découvrir une portion de la surface inférieure de la couche 129 de la diode tunnel. Les connections des contacts 141 et 143 de la diode tunnel sont alors ramenées vers la face 122 de la cellule solaire opposée à la face destinée à être exposée au rayonnement lumineux. On obtient ainsi une cellule solaire du type de celle illustrée en figure 6. Des vias conducteurs peuvent également être formés à travers l'empilement des sous-cellules pour ramener les connections de l'électrode 135 vers la face 122 de la cellule solaire.

Selon une autre variante du procédé illustré en figures 8A-8D, les contacts 135, 139, 141, 143 peuvent être formés sous forme de vias conducteurs.

## Revendications

1. Cellule solaire comprenant :
- un empilement d'au moins deux sous-cellules (23, 25), une diode tunnel (27), comportant une première et une seconde couches superposées (29, 31) dopées selon des types de conductivités opposés, étant interposée entre deux sous-cellules voisines ;
- une première électrode (35) et une deuxième électrode (39) respectivement en contact avec l'une (28) et l'autre (22) des faces de l'empilement ; et pour au moins une diode tunnel (27), une troisième électrode (41) et une quatrième électrode (43) respectivement en contact électrique avec la première couche (31) et la seconde couche (29) de la diode tunnel.

2. Cellule solaire selon la revendication 1, dans laquelle :
- la première électrode (35) est en contact avec la face (28) de l'empilement destinée à être exposée au rayonnement lumineux ; et
- la deuxième électrode (39) est en contact avec la face (22) de l'empilement opposée à ladite face destinée à être exposée au rayonnement lumineux.

3. Cellule solaire selon la revendication 2, dans laquelle, pour ladite au moins une diode tunnel (27), les troisième et quatrième électrodes (41, 43) sont respectivement en contact, éventuellement direct, avec les première et seconde couches (31, 29) de la diode tunnel, toutes deux du côté de la face (28) de l'empilement destinée à être exposée au rayonnement lumineux, ou du côté de la face (22) de l'empilement opposée à ladite face destinée à être exposée au rayonnement lumineux..

4. Cellule solaire selon l'une quelconque des revendications 1 à 3, dans laquelle, pour chaque diode tunnel (27), une troisième électrode (41) et une quatrième électrode (43) sont respectivement en contact électrique avec la première couche (31) et la seconde couche (29) de la diode tunnel.

5. Cellule solaire selon l'une quelconque des revendications 1 à 3, dans laquelle au moins deux sous-cellules voisines (63, 65) sont séparées par une diode tunnel (69) dont la première couche (73) et la seconde couche (71) ne sont en contact avec aucune électrode, lesdites au moins deux sous-cellules voisines formant un ensemble de sous-cellules destinées à être connectées en série.

6. Cellule solaire selon l'une quelconque des revendications 1 à 5, dans laquelle, pour au moins une diode tunnel (27), la diode tunnel comporte en outre une première et une seconde couches barrière conductrices, disposées de part et d'autre de l'empilement des première et seconde couches (29, 31), respectivement en contact avec la première couche (31) et avec la seconde couche (29), la troisième électrode (41) est en contact direct avec la première couche barrière et/ou la quatrième électrode (43) est en contact direct avec la seconde couche barrière.

7. Procédé de formation d'une cellule solaire, comprenant les étapes suivantes :
a) former un empilement d'au moins deux sous-cellules (123, 125), une diode tunnel (127), comportant une première et une seconde couches superposées (129, 131) dopées selon des types de conductivités opposés, étant interposée entre deux sous-cellules voisines;
puis, dans un ordre quelconque :
b) former une première électrode (135) et une deuxième électrode (139) respectivement en contact avec la face (128) de l'empilement destinée à être exposée au rayonnement lumineux et avec la face (122) de l'empilement opposée à ladite face destinée à être exposée au rayonnement lumineux ; et
c) pour au moins une diode tunnel (127), former une troisième électrode (141) et une quatrième électrode (143) respectivement en contact électrique avec la première couche (131) et la seconde couche (129) de la diode tunnel.

8. Procédé selon la revendication 7, comprenant en outre, entre les étapes a) et c), une étape de formation, pour au moins une diode tunnel (127), d'une première ouverture (133) et d'une seconde ouverture (134) de façon à découvrir respectivement une portion (132) de la première couche (131) et une portion (130) de la seconde couche (129) de la diode tunnel.

9. Procédé selon la revendication 8, dans lequel l'étape de formation, pour au moins une diode tunnel (127), des première et seconde ouvertures (133, 134) est réalisée avant l'étape b) de formation des première et deuxième électrodes (135, 139).

10. Procédé selon la revendication 8 ou 9, dans lequel les première et seconde ouvertures (133, 134) sont formées toutes deux à partir de la face (128) de l'empilement destinée à être exposée au rayonnement lumineux ou à partir de la face (122) de l'empilement opposée à ladite face destinée à être exposée au rayonnement lumineux.

11. Procédé d'utilisation d'une cellule solaire selon l'une quelconque des revendications 1 à 6, comprenant les étapes suivantes :
a) mesurer (101) le courant délivré par chaque sous-cellule (23, 25) ou ensemble de sous-cellules connectées en série (63, 65) ;
b) comparer (103) les courants délivrés par les différentes sous-cellules ou ensembles de sous-cellules ;
c) si les courants délivrés par les différentes sous-cellules ou ensembles de sous-cellules sont égaux, connecter (105) la cellule solaire de sorte qu'elle fonctionne en mode monolithique ;
c') si les courants délivrés par les différentes sous-cellules ou ensembles de sous-cellules ne sont pas tous égaux entre eux, connecter (107) la cellule solaire de sorte qu'elle fonctionne en mode multi-terminal.

12. Procédé d'utilisation d'une cellule solaire selon la revendication 11, dans lequel, pour chaque diode tunnel (27) dont la première couche (31) et la seconde couche (29) sont respectivement en contact avec une troisième électrode (41) et une quatrième électrode (43) :
- lors de l'étape c), les troisième et quatrième électrodes (41, 43) ne sont pas connectées et la diode tunnel est électriquement conductrice, et avantageusement une différence de potentiel est appliquée entre les première et deuxième électrodes (35, 39) de sorte que la puissance délivrée par la cellule solaire soit maximale ;
- lors de l'étape c'), une différence de potentiel (Vv) est appliquée entre les troisième et quatrième électrodes (41, 43) de sorte que le courant traversant la diode tunnel soit minimal, et avantageusement pour chaque diode tunnel (27) dont la première couche (31) et la seconde couche (29) sont respectivement en contact avec une troisième électrode (41) et une quatrième électrode (43), on recherche la différence de potentiel (Vv) à appliquer entre les troisième et quatrième électrodes (41, 43) pour que le courant traversant la diode tunnel soit minimal.

13. Procédé d'utilisation d'une cellule solaire selon la revendication 11 ou 12, dans lequel, lors de l'étape c'), pour chaque sous-cellule (23, 25) ou ensemble de sous-cellules connectées en série (63, 65), on recherche la polarisation optimale (Vmax) de la sous-cellule ou de l'ensemble de sous-cellules pour laquelle la puissance délivrée par la sous-cellule ou par l'ensemble de sous-cellules est maximale, et avantageusement chaque électrode (35, 39, 41, 43) de la cellule solaire est polarisée de sorte que chaque sous-cellule ou ensemble de sous-cellules soit polarisé à ladite polarisation optimale.

14. Procédé d'utilisation d'une cellule solaire selon l'une quelconque des revendications 11 à 13, comprenant en outre une étape d) consistant à répéter, avantageusement à intervalles de temps réguliers, les étapes a) à c) ou les étapes a) à c').

15. Procédé d'utilisation d'une cellule solaire selon l'une quelconque des revendications 1 à 6, comprenant les étapes suivantes :
a) mesurer (101) le courant délivré par chaque sous-cellule (23, 25),
b) comparer (103) les courants délivrés par les différentes sous-cellules,
c) si les courants délivrés par les différentes sous-cellules sont égaux, connecter (105) la cellule solaire de sorte qu'elle fonctionne en mode monolithique,
c') si les courants délivrés par les différentes sous-cellules ne sont pas tous égaux entre eux :
- connecter les sous-cellules voisines qui délivrent le même courant en mode monolithique,
- connecter les autres sous-cellules en mode multi-terminal.

## Patentansprüche

1. Solarzelle, umfassend:
- einen Stapel von wenigstens zwei Unterzellen (23, 25), wobei eine Tunneldiode (27), die eine erste und eine zweite überlagerte Schicht (29, 31) umfasst, welche gemäß entgegengesetzten Leitfähigkeitstypen dotiert sind, zwischen zwei benachbarten Unterzellen eingefügt ist;
- eine erste Elektrode (35) und eine zweite Elektrode (39), die in Kontakt mit der einen (28) beziehungsweise der anderen (22) von den Flächen des Stapels sind; und
für wenigstens eine Tunneldiode (27) eine dritte Elektrode (41) und eine vierte Elektrode (43), die in elektrischem Kontakt mit der ersten Schicht (31) beziehungsweise der zweiten Schicht (29) der Tunneldiode sind.

2. Solarzelle nach Anspruch 1, bei der:
- die erste Elektrode (35) in Kontakt ist mit der Fläche (28) des Stapels, die dazu bestimmt ist, der Lichtstrahlung ausgesetzt zu sein; und
- die zweite Elektrode (39) in Kontakt mit der Fläche (22) des Stapels ist, die der Fläche entgegengesetzt ist, die dazu bestimmt ist, der Lichtstrahlung ausgesetzt zu sein.

3. Solarzelle nach Anspruch 2, bei der für die wenigstens eine Tunneldiode (27) die dritte und die vierte Elektrode (41, 43) in eventuell direktem Kontakt mit der ersten beziehungsweise der zweiten Schicht (31, 29) der Tunneldiode sind, beide auf der Seite der Fläche (28) des Stapels, die dazu bestimmt ist, der Lichtstrahlung ausgesetzt zu sein, oder auf der Seite der Fläche (22) des Stapels, die entgegengesetzt ist zu der Fläche, die dazu bestimmt ist, der Lichtstrahlung ausgesetzt zu sein.

4. Solarzelle nach einem der Ansprüche 1 bis 3, bei der für jede Tunneldiode (27) eine dritte Elektrode (41) und eine vierte Elektrode (43) in elektrischem Kontakt mit der ersten Schicht (31) beziehungsweise der zweiten Schicht (29) der Tunneldiode sind.

5. Solarzelle nach einem der Ansprüche 1 bis 3, bei der wenigstens zwei benachbarte Unterzellen (63, 65) durch eine Tunneldiode (69) separiert sind, deren erste Schicht (73) und zweite Schicht (71) nicht in Kontakt mit irgendeiner Elektrode sind, wobei die wenigstens zwei benachbarten Unterzellen eine Gruppe von Unterzellen bilden, die dazu bestimmt sind, in Reihe verbunden zu sein.

6. Solarzelle nach einem der Ansprüche 1 bis 5, bei der für wenigstens eine Tunneldiode (27) die Tunneldiode ferner eine leitfähige erste und zweite Barriereschicht umfasst, die auf beiden Seiten des Stapels der ersten und zweiten Schicht (29, 31) in Kontakt mit der ersten Schicht (31) beziehungsweise mit der zweiten Schicht (29) angeordnet sind, wobei die dritte Elektrode (41) in direktem Kontakt mit der ersten Barriereschicht ist, und/oder die vierte Elektrode (43) in direktem Kontakt mit der zweiten Barriereschicht ist.

7. Verfahren zur Bildung einer Solarzelle, umfassend die folgenden Schritte:
a) Bilden eines Stapels von wenigstens zwei Unterzellen (123, 125), wobei eine Tunneldiode (127), die eine erste und eine zweite überlagerte Schicht (129, 131) umfasst, die gemäß entgegengesetzten Leitfähigkeitstypen dotiert sind, zwischen zwei benachbarten Unterzellen eingefügt wird;
dann, in einer beliebigen Reihenfolge:
b) Bilden einer ersten Elektrode (135) und einer zweiten Elektrode (139) in Kontakt mit der Fläche (128) des Stapels, die dazu bestimmt ist, der Lichtstrahlung ausgesetzt zu sein, beziehungsweise mit der Fläche (122) des Stapels entgegengesetzt zu der Fläche, die dazu bestimmt ist, der Lichtstrahlung ausgesetzt zu sein; und
c) für wenigstens eine Tunneldiode (127), Bilden einer dritten Elektrode (141) und einer vierten Elektrode (143) in elektrischem Kontakt mit der ersten Schicht (131) beziehungsweise der zweiten Schicht (129) der Tunneldiode.

8. Verfahren nach Anspruch 7, ferner umfassend zwischen den Schritten a) und c) einen Schritt des Bildens, für wenigstens eine Tunneldiode (127), einer ersten Öffnung (133) und einer zweiten Öffnung (134) derart, dass ein Bereich (132) der ersten Schicht (131) beziehungsweise ein Bereich (130) der zweiten Schicht (129) der Tunneldiode freigelegt wird.

9. Verfahren nach Anspruch 8, bei dem der Schritt des Bildens, für wenigstens eine Tunneldiode (127), der ersten und der zweiten Öffnung (133, 134) vor dem Schritt b) des Bildens der ersten und der zweiten Elektrode (135, 139) realisiert wird.

10. Verfahren nach Anspruch 8 oder 9, bei dem die erste und die zweite Öffnung (133, 134) beide ausgehend von der Fläche (128) des Stapels gebildet werden, die dazu bestimmt ist, der Lichtstrahlung ausgesetzt zu sein, oder ausgehend von der Fläche (122) des Stapels, die entgegengesetzt ist zu der Fläche, die dazu bestimmt ist, der Lichtstrahlung ausgesetzt zu sein.

11. Verfahren zur Verwendung einer Solarzelle nach einem der Ansprüche 1 bis 6, umfassend die folgenden Schritte:
a) Messen (101) des Stroms, der durch jede Unterzelle (23, 25) oder Gruppe von in Reihe verbundenen Unterzellen (63, 65) geliefert wird;
b) Vergleichen (103) der Ströme, die durch die verschiedenen Unterzellen oder Gruppen von Unterzellen geliefert werden;
c) wenn die Ströme, die durch die verschiedenen Unterzellen oder Gruppen von Unterzellen geliefert werden, gleich sind, Anschließen (105) der Solarzelle derart, dass sie in einem monolithischen Modus funktioniert;
c') wenn die Ströme, die durch die verschiedenen Unterzellen oder Gruppen von Unterzellen geliefert werden, nicht alle zueinander gleich sind, Anschließen (107) der Solarzelle derart, dass sie in einem Multiterminalmodus funktioniert.

12. Verfahren zur Verwendung einer Solarzelle nach Anspruch 11, bei dem für jede Tunneldiode (27), deren erste Schicht (31) und zweite Schicht (29) in Kontakt mit einer dritten Elektrode (41) beziehungsweise einer vierten Elektrode (43) sind:
- während des Schritts c) die dritte und die vierte Elektrode (41, 43) nicht angeschlossen sind, und die Tunneldiode elektrisch leitend ist, und vorzugsweise eine Potentialdifferenz zwischen der ersten und der zweiten Elektrode (35, 39) angelegt wird, derart, dass die durch die Solarzelle gelieferte Leistung maximal ist;
- während des Schritts c') eine Potentialdifferenz (Vv) zwischen der dritten und vierten Elektrode (41, 43) angelegt wird, derart, dass der Storm, der die Tunneldiode durchfließt, minimal ist, und vorzugsweise für jede Tunneldiode (27), deren erste Schicht (31) und zweite Schicht (29) in Kontakt mit einer dritten Elektrode (41) beziehungsweise einer vierten Elektrode (43) ist, man die Potentialdifferenz (Vv) sucht, die zwischen der dritten und vierten Elektrode (41, 43) anzulegen ist, damit der Strom, der die Tunneldiode durchfließt, minimal ist.

13. Verfahren zur Verwendung einer Solarzelle nach Anspruch 11 oder 12, bei dem während des Schritts c') für jede Unterzelle (23, 25) oder Gruppe von in Reihe angeschlossenen Unterzellen (63, 65) man die optimale Polarisation (Vmax) der Unterzelle oder der Gruppe von Unterzellen sucht, für die die Leistung, die durch die Unterzelle oder durch die Gruppe von Unterzellen geliefert wird, maximal ist, und vorzugsweise jede Elektrode (35, 39, 41, 43) der Solarzelle derart polarisiert wird, dass jede Unterzelle oder Gruppe von Unterzellen mit der optimalen Polarisation polarisiert ist.

14. Verfahren zur Verwendung einer Solarzelle nach einem der Ansprüche 11 bis 13, ferner umfassend einen Schritt d), der darin besteht, die Schritte a) bis c) oder die Schritte a) bis c') zu wiederholen, vorzugsweise in gleichmäßigen Zeitintervallen.

15. Verfahren zur Verwendung einer Solarzelle nach einem der Ansprüche 1 bis 6, umfassend die folgenden Schritte:
a) Messen (101) des Stroms, der durch jede Unterzelle (23, 25) geliefert wird,
b) Vergleichen (103) der Ströme, die durch die verschiedenen Unterzellen geliefert werden,
c) wenn die Ströme, die durch die verschiedenen Unterzellen geliefert werden, gleich sind, Anschließen (105) der Solarzelle derart, dass sie in einem monolithischen Modus funktioniert,
c') wenn die Ströme, die durch die verschiedenen Unterzellen geliefert werden, nicht alle zueinander gleich sind:
- Anschließen der benachbarten Unterzellen, die den gleichen Strom liefern, in einem monolithischen Modus,
- Anschließen der anderen Unterzellen in einem Multiterminalmodus.

## Claims

1. A solar cell including:
a stack of at least two sub-cells (23, 25), where a tunnel diode (27), including first and second superposed layers (29, 31) which are doped with opposite conductivity types, is interposed between two adjacent sub-cells;
a first electrode (35) and a second electrode (39) in contact respectively with one face (28) and the other face (22) of the stack; and
for at least one tunnel diode (27), a third electrode (41) and a fourth electrode (43) respectively in electrical contact with the first layer (31) and the second layer (29) of the tunnel diode.

2. A solar cell according to claim 1, in which:
- the first electrode (35) is in contact with the face (28) of the stack intended to be exposed to the light radiation; and
- the second electrode (39) is in contact with the face (22) of the stack opposite the said face intended to be exposed to the light radiation.

3. A solar cell according to claim 2, in which, for the said at least one tunnel diode (27), the third and fourth electrodes (41, 43) are respectively in contact, possibly in direct contact, with the first and second layers (31, 29) of the tunnel diode, on the side of the face (28) of the stack intended to be exposed to the light radiation or on the side of the face (22) of the stack opposite the said face intended to be exposed to the light radiation.

4. A solar cell according to any one of claims 1 to 3, in which, for each tunnel diode (27), a third electrode (41) and a fourth electrode (43) are respectively in electrical contact with the first layer (31) and the second layer (29) of the tunnel diode.

5. A solar cell according to any one of claims 1 to 3, in which at least two adjacent sub-cells (63, 65) are separated by a tunnel diode (69) the first layer (73) and the second layer (71) of which are not in contact with any electrode, where the said at least two adjacent sub-cells form an assembly of sub-cells intended to be connected in series.

6. A solar cell according to any one of claims 1 to 5, in which, for at least one tunnel diode (27), the tunnel diode also includes a first and second conductive barrier layers, positioned either side of the stack of the first and second layers (29, 31), respectively in contact with the first layer (31) and with the second layer (29), the third electrode (41) is in direct contact with the first barrier layer and/or the fourth electrode (43) is in direct contact with the second barrier layer.

7. A method for forming a solar cell, including the following steps:
a) forming a stack of at least two sub-cells (123, 125), where a tunnel diode (127), including first and second superposed layers (129, 131) which are doped with opposite conductivity types, is interposed between two adjacent sub-cells;
subsequently, in any order:
b) forming a first electrode (135) and a second electrode (139) respectively in contact with the face (128) of the stack intended to be exposed to the light radiation and with the face (122) of the stack opposite the said face intended to be exposed to the light radiation; and
c) for at least one tunnel diode (127), forming a third electrode (141) and a fourth electrode (143) respectively in electrical contact with the first layer (131) and the second layer (129) of the tunnel diode.

8. A method according to claim 7, also including, between steps a) and c), a step of formation, for at least one tunnel diode (127), of a first opening (133) and of a second opening (134), so as to expose respectively a portion (132) of the first layer (131) and a portion (130) of the second layer (129) of the tunnel diode.

9. A method according to claim 8, in which the step of formation, for at least one tunnel diode (127), of the first and second openings (133, 134), is performed before step b) of formation of the first and second electrodes (135, 139).

10. A method according to any one of claims 8 or 9, in which the first and second openings (133, 134) are formed from the face (128) of the stack intended to be exposed to the light radiation or from the face (122) of the stack opposite the said face intended to be exposed to the light radiation.

11. A method of using a solar cell according to any one of claims 1 to 8, including the following steps:
a) measuring (101) the current delivered by each sub-cell (23, 25) or assembly of sub-cells connected in series (63, 65);
b) comparing (103) the currents delivered by the different sub-cells or assemblies of sub-cells;
c) if the currents delivered by the different sub-cells or assemblies of sub-cells are equal, connecting (105) the solar cell such that it operates in monolithic mode;
c') if the currents delivered by the different sub-cells or assemblies of sub-cells are not all equal, connecting (107) the solar cell such that it operates in multi-terminal mode.

12. A method of using a solar cell according to claim 11, in which, for each tunnel diode (27) of which the first layer (31) and the second layer (29) are respectively in contact with a third electrode (41) and a fourth electrode (43):
- in step c), the third and fourth electrodes (41, 43) are not connected and the tunnel diode is electrically conductive, and advantageously a potential difference is applied between the first and second electrodes (35, 39) such that the power delivered by the solar cell is maximum;
- in step c'), a potential difference (Vv) is applied between the third and fourth electrodes (41, 43) such that the current flowing through the tunnel diode is minimalsecond electrodes (35, 39) such that the power delivered by the solar cell is maximum and advantageously for each tunnel diode (27) of which the first layer (31) and the second layer (29) are respectively in contact with a third electrode (41) and a fourth electrode (43), it is sought to determine the potential difference (Vv) to be applied between the third and fourth electrodes (41, 43) for the current flowing through the tunnel diode to be minimal

13. A method of using a solar cell according to any one of claims 11 or 12 in which, in step c'), for each sub-cell (23, 25) or assembly of sub-cells connected in series (63, 65), it is sought to determine the optimum polarisation (Vmax) of the sub-cell or of the assembly of sub-cells for the power delivered by the sub-cell or by the assembly of sub-cells to be maximum, and advantageously, each electrode (35, 39, 41, 43) of the solar cell is polarised such that each sub-cell or assembly of sub-cells is polarised at the said optimum polarisation.

14. A method of using a solar cell according to any one of claims 11 to 13, also including a step d) consisting in repeating steps a) to c) or steps a) to c'), and advantageously step d) is repeated at regular time intervals.

15. A method of using a solar cell according to any one of claims 1 to 8, including the following steps:
a) measuring (101) the current delivered by each sub-cell (23, 25);
b) comparing (103) the currents delivered by the different sub-cells;
c) if the currents delivered by the different sub-cells are equal, connecting (105) the solar cell such that it operates in monolithic mode;
c') if the currents delivered by the different sub-cells are not all equal:
- connecting the adjacent sub-cells which deliver the same current in monolithic mode;
- connecting the other sub-cells in multi-terminal mode.
